# EUROPÄISCHE PATENTSCHRIFT

(11) **EP 0 615 670 B1**
(45) Veröffentlichungstag und Bekanntmachung des Hinweises auf die Patenterteilung: **29.10.1997**
(21) Anmeldenummer: 93921879.8
(22) Anmeldetag: 29.09.1993
(51) Int. Cl.: H03J 1/00

(54) **VERFAHREN ZUR ABSTIMMUNG EINES RUNDFUNKEMPFÄNGERS MITTELS STATIONSTASTEN**
PROCESS FOR TUNING A RADIO RECEIVER BY MEANS OF STATION KEYS
PROCEDE DE SYNTONISATION D'UN RECEPTEUR RADIOPHONIQUE AU MOYEN DE TOUCHES ASSOCIEES A DES STATIONS

(30) Priorität: 02.10.1992 DE 4233260
(43) Veröffentlichungstag der Anmeldung: 21.09.1994
(73) Patentinhaber: BECKER GmbH, D-76307 Karlsbad (DE)
(72) Erfinder: KLOS, Rainer, D-76275 Ettlingen (DE)
(74) Vertreter: Degwert, Hartmut, Dipl.-Phys.
(86) Internationale Anmeldenummer: EP9302649
(87) Internationale Veröffentlichungsnummer: WO9408397

(56) Entgegenhaltungen:
- EP-A- 0 305 172
- DE-A- 3 148 085
- DE-A- 3 149 409
- DE-A- 3 404 976

## Beschreibung

Die Erfindung betrifft ein Verfahren zur Abstimmung eines Rundfunkempfängers mittels Stationstasten auf je eine aus einer Mehrzahl von Senderfrequenzen, die in selektiver Zuordnung zu den Stationstasten abgespeichert werden, wobei unter jeder Stationstaste maximal eine vorbestimmte Anzahl von Senderfrequenzen in je einem zugeordneten Speicherfeld abgespeichert wird.

Ein Verfahren dieser Art findet bevorzugt in mobilen Rundfunkempfängern Anwendung, insbesondere Autoradios. Um dem größer werdenden Angebot von Sendern, die in einem bestimmten Gebiet mit guter Qualität empfangen werden können, gerecht zu werden, können unter jeder Stationstaste mehrere Senderfrequenzen abgespeichert werden. Auf diese Weise wird zwar eine Vervielfältigung der Stationstasten vermieden, jedoch wird ein gesondertes Bedienelement benötigt, um zwischen den verschiedenen Speicherebenen umzuschalten. Zur Auswahl eines der unter den Stationstasten gespeicherten Senders sind zwei Bedienvorgänge notwendig, nämlich die Auswahl der Speicherebene und die Auswahl der Stationstaste.

EP-A-305 172 zeigt einen RDS Empfänger bei dem jeder Stationstaste ein Speicherbereich (MASn) zugeordnet ist, auf dessen Speicherplätzen vom Empfänger während der Fahrt automatisch Frequenzen von Sendern mit gleichem Programminhalt (Lokales, Klassik etc.) abgespeichert werden. Der Fahrer kann nun durch mehrmaliges Betätigen der Stationstaste diese Programme einstellen. Es ist nicht vorgesehen das der Fahrer selbst Frequenzen von Sendern seiner Wahl auf den Speicherplätzen einer Stationstaste abspeichern kann.

Bei dem erfindungsgemäßen Verfahren entfällt die Betätigung eines gesonderten Bedienelementes zur Auswahl der gewünschten Speicherebene. Gemäß der Erfindung werden unter jeder Stationstaste die Senderfrequenzen in einer vorbestimmten Reihenfolge abgespeichert, indem bei Betätigung der Stationstaste während einer vorbestimmten Mindestdauer die aktuell eingestellte Senderfrequenz in das zu diesem Zeitpunkt eingestellte Speicherfeld eingeschrieben wird; die unter einer Stationstaste abgespeicherten Senderfrequenzen werden nun durch mehrmaliges Betätigen dieser Stationstaste nacheinander in der vorbestimmten Reihenfolge eingestellt. Da bei jeder Betätigung einer Stationstaste die Speicherebene gewechselt wird, erübrigt sich die Betätigung eines gesonderten Bedienelements zur Auswahl der gewünschten Speicherebene. Es hat sich gezeigt, daß die Auswahl des gewünschten Senders durch mehrfaches Betätigen einer Stationstaste mit größerer Sicherheit erfolgt als bei Betätigung von gesonderten Bedienelementen, von denen eines für die Umschaltung zwischen den Speicherebenen zuständig ist. Wenn bei dem Versuch, den gewünschten Sender einzustellen, die falsche Speicherebene gewählt wurde, müssen bei dem herkömmlichen Verfahren beide Bedienelemente erneut betätigt werden. Bei dem erfindungsgemäßen Verfahren wird hingegen lediglich die Stationstaste, unter welcher der gewünschte Sender gespeichert ist, nochmals betätigt. Diese Vereinfachung der Bedienung ist bei Autoradios ein hoher Sicherheitsvorteil.

Die Anzahl von Senderfrequenzen, die unter einer Stationstaste gespeichert werden können, sollte nicht zu groß sein, damit die Auswahl der durch Betätigung von Stationstasten einstellbaren Senderfrequenzen übersichtlich bleibt. Sie wird beispielsweise auf drei beschränkt. Wenn nun aber unter einer Stationstaste bereits alle Speicherfelder belegt sind und unter derselben Stationstaste eine neue Senderfrequenz gespeichert werden soll, wird nach einer vorteilhaften Weiterbildung des Verfahrens die aktuell - beispeilsweise mittels Sendersuchlauf - eingestellte Senderfrequenz in das in der vorbestimmten Reihenfolge letzte Speicherfeld eingeschrieben, und die vorausgehenden Speicherfelder werden jeweils mit der Senderfrequenz des unmittelbar darauffolgenden Speicherfeldes überschrieben. Auf diese Weise wird stets die zuerst eingespeicherte Senderfrequenz überschrieben; die später abgespeicherten Senderfrequenzen bleiben erhalten, da unterstellt wird, daß sie von größerer Aktualität sind.

Das erfindungsgemäße Verfahren eröffnet Möglichkeiten zu sehr vorteilhaften Weiterbildungen.

Gemäß einer ersten Weiterbildung kann eine Umsortierung der unter den Stationstasten gespeicherten Senderfrequenzen erfolgen. Zu diesem Zweck wird eine unter einer Stationstaste bereits in einem bestimmten Speicherfeld eingeschriebene Senderfrequenz durch Betätigung der betreffenden Stationstaste zunächst eingestellt und dann durch erneutes Betätigen der Stationstaste während der vorbestimmten Mindestdauer in das erste Speicherfeld eingeschrieben, dessen Inhalt seinerseits in dasjenige Speicherfeld eingeschrieben wird, dessen Inhalt in das erste Speicherfeld eingeschrieben wurde. Bei Bedarf kann dieser Vorgang in der gewünschten Reihenfolge wiederholt werden, bis alle unter der Stationstaste gespeicherten Senderfrequenzen in der gewünschten Reihenfolge abgespeichert sind.

Gemäß einer zweiten vorteilhaften Weiterbildung wird bei Betätigung einer Stationstaste zur Einstellung auf eine Senderfrequenz zunächst die sich bei dieser Frequenz ergebende Empfangsqualität geprüft. Wenn sie unbefriedigend ist, wird automatisch auf die in dem darauffolgenden Speicherfeld unter derselben Stationstaste eingeschriebene Senderfrequenz umgeschaltet. Die sich durch diese Weiterbildung ergebenden Vorteile werden an dem folgenden Beispiel deutlich: Bei einem Autoradio werden unter einer bestimmten Stationstaste die Senderfrequenzen von Verkehrsfunksendern gespeichert, die in verschiedenen Verkehrsfunkbereichen empfangen werden können; bei der Fahrt durch diese Verkehrsfunkbereiche kann nun der Benutzer durch einfaches Betätigen der entsprechenden Stationstaste die jeweils relevanten Verkehrsfunksender einstellen. Diese Ausführungsform kann noch vorteilhafter gestaltet werden, indem die Empfangsqualität des eingestellten Senders ständig oder periodisch überwacht wird und bei Nichterfüllung bestimmter Kriterien automatisch auf die in dem darauffolgenden Speicherfeld eingeschriebene Senderfrequenz umgeschaltet wird. Auf diese Weise wird eine automatische Umschaltung auf dem jeweils zutreffenden Verkehrsfunkbereich gewährleistet.

Das erfindungsgemäße Verfahren und seine Weiterbildungen werden nun unter Bezugnahme auf die beigefügte Zeichnung näher beschrieben. In der Zeichnung zeigen:
- Fig. 1: eine Frontansicht eines mit Stationstasten ausgestatteten Autoradios;
- Fig. 2a bis 2d: die drei einer Stationstaste zugeordneten Speicherfelder in verschiedenen Zuständen;
- Fig. 3: die drei Speicherfelder einer Stationstaste im Verlaufe einer Umsortierung ihrer Inhalte; und
- Fig. 4: die Speicherfelder einer Reihe von Stationstasten mit den darin gespeicherten Inhalten.

Das Verfahren wird nun in Anwendung auf ein Autoradio näher beschrieben.

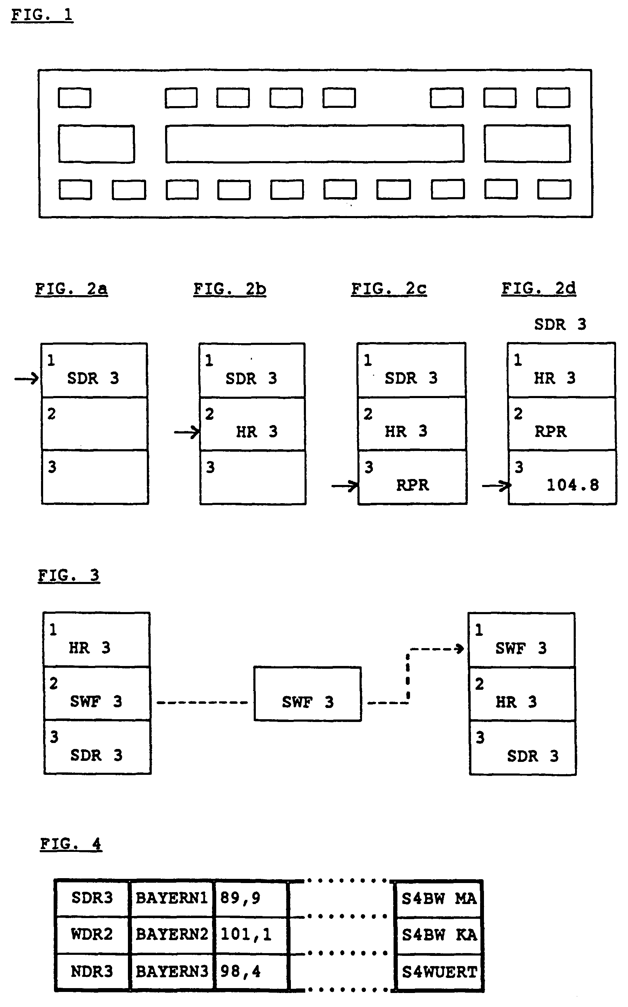

Die in Fig. 1 gezeigte Bedienfront eines Autoradios ist in drei übereinander angeordnete Zeilen gegliedert, von denen die erste eine Reihe von Bedientasten, die zweite u.a. ein alphanumerisches Anzeigefeld und die dritte zehn Stationstasten enthält. Da nur diese Stationstasten von Interesse sind, wird auf andere Einzelheiten des Autoradios nicht näher eingegangen.

Unter jeder Stationstaste können mehrere, bei der gezeigten Ausführungsform drei, Senderfrequenzen gespeichert werden. Jeder Stationstaste sind daher drei Speicherfelder eines nichtflüchtigen Speichers zugeordnet, der zu dem Steuerteil des Autoradios gehört. In den Figuren 2a bis 2d sind die drei Speicherfelder einer Stationstaste jeweils mit verschiedenen Inhalten dargestellt. Sie folgen in einer vorbestimmten Reihenfolge aufeinander. In Fig. 2a ist durch Betätigen der Stationstaste während einer Dauer von etwa 2 Sekunden die Senderfrequenz des gerade über Sendersuchlauf eingestellten Senders SDR3 in das erste Speicherfeld übernommen worden. Der die Speicherebene bezeichnende Zeiger, in den Figuren 2a bis 2d durch einen Pfeil symbolisiert, zeigt auf das erste Speicherfeld.

Durch nochmaliges Betätigen der Stationstaste wird der Zeiger vom Speicherfeld 1 auf das Speicherfeld 2 bewegt, wie in Fig. 2b gezeigt. Wenn nun die Stationstaste während einer Dauer von etwa 2 Sekunden betätigt wird, erfolgt die Übernahme der Senderfrequenz des aktuell eingestellten Senders, bei diesem Beispiel der Sender HR3, in das zweite Speicherfeld.

In gleicher Weise wird im dritten Speicherfeld die Senderfrequenz eines dritten Senders eingespeichert, hier des Senders RPR.

Nachdem die drei Speicherfelder der Stationstaste belegt sind, kann eine neue Senderfrequenz nur durch Überschreiben des Inhalts eines bereits belegten Speicherfeldes aufgenommen werden. Diesen Vorgang veranschaulicht Fig. 2d. Der Zeiger steht auf dem dritten Speicherfeld, dessen Inhalt nun durch eine neue Senderfrequenz ersetzt wird, was durch die Zahl 104.8 veranschaulicht ist. Von den drei zuvor abgespeicherten Senderfrequenzen bleiben die mit der höchsten Aktualität erhalten, nämlich die der Sender RPR und HR3, die in das jeweils vorausgehende Speicherfeld überführt werden. Die zuerst in das erste Speicherfeld eingegebene Senderfrequenz des Senders SDR3 wird überschrieben.

Die Inhalte der drei belegten Speicherfelder einer Stationstaste können gemäß einer Weiterbildung des Verfahrens nach Belieben umsortiert werden. Dieser Vorgang ist in Fig. 3 veranschaulicht. Bei diesem Beispiel wird angenommen, daß die Senderfrequenz des im zweiten Speicherfeld abgespeicherten Senders SWF3 in das erste Speicherfeld verlagert werden soll. Zu diesem Zweck wird zunächst der Sender SWF3 durch zweimaliges Betätigen der betreffenden Stationstaste eingestellt. Anschließend wird diese Stationstaste erneut während einer Dauer von etwa 2 Sekunden betätigt. Durch diesen Vorgang werden die Inhalte der Speicherfelder 1 und 2 vertauscht. In gleicher Weise könnte der Inhalt des dritten Speicherfeldes (SDR3) in das erste Speicherfeld übertragen werden, wobei dann der vorherige Inhalt des ersten Speicherfeldes in das dritte Speicherfeld überführt wird.

Das beschriebene Verfahren eröffnet vielfältige Bedienungsvarianten, die in das Belieben des Benutzers gestellt sind. Einige dieser Möglichkeiten sind in Fig. 4 dargestellt. In den Speicherfeldern der ersten Stationstaste werden bei dem gezeigten Beispiel drei Verkehrsfunksender verschiedener Verkehrsfunkbereiche abgelegt. In den Speicherfeldern der zweiten Stationstaste werden die Senderfrequenzen verschiedener Programmketten einer Sendeanstalt abgespeichert. In den Speicherfeldern der letzten Stationstaste werden die Senderfrequenzen verschiedener Regionalprogramme einer Sendeanstalt abgelegt.

In weiterer Ausgestaltung des Verfahrens wird bei Einstellung einer Senderfrequenz durch Betätigen einer Stationstaste zunächst die Empfangsqualität geprüft. Falls die Empfangsqualität unbefriedigend ist, wird sofort und automatisch auf das darauffolgende Speicherfeld umgeschaltet; ist bereits das letzte Speicherfeld eingestellt, wird wieder auf das erste umgeschaltet. Durch diese Weiterbildung ergibt sich eine sehr vorteilhafte Arbeitsweise, die ebenfalls anhand von Fig. 4 ersichtlich wird. Der Benutzer hat beispielsweise auf der dritten Stationstaste drei verschiedene Senderfrequenzen eines bestimmten Rundfunkprogramms abgespeichert. Je nach dem Standort des Autoradios ändern sich die relativen Empfangsverhältnisse für die drei verschiedenen Sender, die dasselbe Rundfunkprogramm ausstrahlen. Ist bei Betätigung der dritten Stationstaste die Empfangsqualität unbefriedigend, wird sofort auf das nächste Speicherfeld umgeschaltet. Eine Umschaltung auf das nächste Speicherfeld erfolgt auch automatisch, wenn sich im Verlauf der Fahrt die Empfangsqualität verschlechtert, so daß ein Frequenzwechsel zweckmäßig erscheint.

Wenn hingegen die erste Stationstaste betätigt wird und das Fahrzeug sich außerhalb des Empfangsbereichs des Verkehrsfunksenders befindet, dessen Frequenz in dem gerade eingestellten Speicherfeld abgespeichert ist, so wird automatisch auf das nächste Speicherfeld umgeschaltet. Eine Umschaltung erfolgt auch, wenn im Verlaufe der Fahrt die Empfangsqualität des gerade eingestellten Verkehrsfunksenders unbefriedigend wird. Der Benutzer wird daher stets von dem für ihn relevanten Verkehrsfunkprogramm begleitet.

Die Anzahl von Speicherfeldern, die einer Stationstaste zugeordnet werden, ist prinzipiell unbegrenzt, da die Bereitstellung des erforderlichen Speicherplatzes beim derzeitigen Stand der Technik keinerlei Schwierigkeiten bereitet. Sie sollte aber nicht zu groß gewählt werden, damit mit wenigen Betätigungen einer Stationstaste alle darunter abgelegten Senderfrequenzen eingestellt werden können.

## Patentansprüche

1. Verfahren zur Abstimmung eines Rundfunkempfängers mittels Stationstasten auf je eine aus einer Mehrzahl von Senderfrequenzen, die in selektiver Zuordung zu den Stationstasten abgespeichert werden, wobei unter jeder Stationstaste maximal eine vorbestimmte Anzahl von Senderfrequenzen in je einem zugeordneten Speicherfeld abgespeichert wird;
a) durch Betätigung einer Stationstaste während einer Dauer, die kürzer ist als eine vorbestimmte Zeitspanne, vom aktuellen auf das jeweils darauffolgende Speicherfeld umgeschaltet wird, und der Rundfunkempfänger auf die darin gespeicherte Sendefrequenz abgestimmt wird,
b) die unter einer Stationstaste abgespeicherten Senderfrequenzen durch mehrmaliges Betätigen dieser Stationstaste nacheinander in einer vorbestimmten Reihenfolge eingestellt werden;
dadurch gekennzeichnet, daß:
c) unter jeder Stationstaste die Senderfrequenzen in der vorbestimmten Reihenfolge abgespeichert werden, indem bei Betätigung der Stationstaste mindestens während der vorbestimmten Zeitspanne die aktuell eingestellte Senderfrequenz in das eingestellte Speicherfeld eingeschrieben wird.

2. Verfahren nach Anspruch 1, dadurch gekennzeichnet, daß bei Überschreitung der vorbestimmten Anzahl von unter einer Stationstaste abgespeicherten Senderfrequenzen die aktuell eingestellte Senderfrequenz in das in der vorbestimmten Reihenfolge letzte Speicherfeld eingeschrieben wird und die vorausgehenden Speicherfelder jeweils mit der Senderfrequenz des unmittelbar darauffolgenden Speicherfeldes überschrieben werden.

3. Verfahren nach Anspruch 1 oder 2, dadurch gekennzeichnet, daß eine unter einer Stationstaste bereits in einem bestimmten Speicherfeld eingeschriebene Senderfrequenz durch Betätigung der Stationstaste zunächst eingestellt und dann durch erneutes Betätigen der Stationstaste während der vorbestimmten Mindestdauer in das erste Speicherfeld eingeschrieben wird, dessen Inhalt seinerseits in dasjenige Speicherfeld eingeschrieben wird, dessen Inhalt in das erste Speicherfeld eingeschrieben wurde.

4. Verfahren nach einem der Ansprüche 1 bis 3, dadurch gekennzeichnet, daß bei durch Betätigung einer Stationstaste erfolgender Einstellung auf eine Senderfrequenz die Empfangsqualität geprüft und bei Nichterfüllung vorbestimmter Empfangsqualitätskriterien automatisch auf die in dem darauffolgenden Speicherfeld eingeschriebene Senderfrequenz umgeschaltet wird.

## Claims

1. A method for tuning a radio receiver by means of station buttons to any one of a plurality of transmitter frequencies, which are stored in selective association with the station buttons, whereby under each station button at most a predetermined number of transmitter frequencies is stored in an associated memory area;
a) by operating a station button during a period which is shorter than a predetermined time interval, switching from the present to the respectively following memory area occurs, and the radio receiver is tuned to the transmitter frequency stored therein,
b) the transmitter frequencies stored under a station button are set by operating this station button several times in succession in a predetermined sequence,
**characterised in that**
c) under each station button the transmitter frequencies are stored in the predetermined sequence by, when actuating the station button at least during the predetermined time interval, the currently set transmitter frequency being written into the set memory area.

2. A method according to Claim 1,
**characterised in that** if the predetermined number of transmitter frequencies stored under one station button is exceeded, the currently set transmitter frequency is written into the last memory area in the predetermined sequence and the preceding memory areas are in each case overwritten with the transmitter frequency of the directly following memory area.

3. A method according to Claim 1 or 2,
**characterised in that** a transmitter frequency already written in a determined memory area under a station button is firstly set by actuating the station button and then is written into the first memory area by the renewed operation of the station button during the predetermined minimum period, and the contents of said memory area are in turn written into that memory area whose contents are written into the first memory area.

4. A method according to one of Claims 1 to 3,
**characterised in that** during the adjustment to a transmitter frequency, which is performed by actuating a station button, the reception quality is tested and if predetermined reception quality criteria are not met, switching over to the transmitter frequency written into the following memory area automatically occurs.

## Revendications

1. Procédé d'accord d'un récepteur radio au moyen de touches de stations, avec chacune sur une d'un certain nombre de fréquences d'émetteurs qui sont mises en mémoire en étant assignées sélectivement aux touches de stations, sous chaque touche de station étant mis en mémoire, au maximum, un nombre déterminé de fréquences d'émetteurs, chacune dans une zone de mémoire assignée;
a) en actionnant une touche de station pendant une durée inférieure à un laps de temps déterminé, on passe de la zone de mémoire actuelle à la zone de mémoire suivante et on accorde le récepteur radio sur la fréquence d'émetteur mise en mémoire dans celle-ci,
b) on règle l'une après l'autre dans un ordre déterminé les fréquences d'émetteurs mises en mémoire sous une touche de station en actionnant plusieurs fois cette touche de station,
caractérisé par le fait :
c) qu'on met en mémoire les fréquences d'émetteurs sous chaque touche de station dans un ordre déterminé en écrivant la fréquence d'émetteur actuellement règlée dans la zone de mémoire établie en actionnant la touche de station pendant au moins le laps de temps déterminé.

2. Procédé selon la revendication 1, caractérisé par le fait qu'en cas de dépassement du nombre déterminé de fréquences d'émetteurs mises en mémoire sous une touche de station, la fréquence d'émetteur actuellement règlée est écrite dans la zone de mémoire qui est la dernière dans l'ordre déterminé et, dans chacune des zones de mémoire précédentes, la fréquence d'émetteur est remplacée par la fréquence d'émetteur de la zone de mémoire immédiatement suivante.

3. Procédé selon l'une des revendications 1 et 2, caractérisé par le fait qu'on commence, en actionnant une touche de station, par établir une fréquence d'émetteur déjà écrite sous cette touche dans une zone de mémoire déterminée, puis, en actionnant de nouveau cette touche pendant la durée minimale déterminée, on ecrit cette fréquence dans la première zone de mémoire, dont on écrit pour sa part le contenu dans la zone de mémoire dont on avait écrit le contenu dans la première zone de mémoire.

4. Procédé selon l'une des revendications 1 à 3, caractérisé par le fait que, lorsqu'on règle le récepteur sur une fréquence d'émetteur en actionnant une touche de station, la qualité de réception est contrôlée, et, si des critères déterminés de qualité de réception ne sont pas remplis, le récepteur passe automatiquement à la fréquence d'émetteur écrite dans la zone de mémoire suivante.
